# EUROPEAN PATENT SPECIFICATION

(11) **EP 1 914 296 B1**
(45) Date of publication and mention of the grant of the patent: **16.03.2011**
(21) Application number: 07118852.8
(22) Date of filing: 19.10.2007
(51) Int. Cl.: C11D 17/00

(54) **Stripper containing an acetal or a ketal for removing post-etched phot-resist, etch polymer and residue**
Abstreifer mit Acetal oder Ketal zur Entfernung nach einem Ätzvorgang verbleibenden Photoresists, Ätzpolymers und sonstiger Reste
Dissolvant contenant un acétal ou un cétal pour l'élimination d'une photorésine, d'un polymère de gravure et de résidus après la gravure

(30) Priority: 19.10.2006 US 852758 P; 05.10.2007 US 868469
(43) Date of publication of application: 23.04.2008
(73) Proprietor: Air Products and Chemicals, Inc., Allentown, PA 18195-1501 (US)
(72) Inventor: Egbe, Matthew I., West Norriton, MA 19403 (US); Legenza, Michael Walter, Bellingham, MA 02019 (US)
(74) Representative: Muir, Benjamin M. J.

(56) References cited:
- EP-A- 1 619 557
- WO-A-2006/097214
- DATABASE WPI Week 199510 Thomson Scientific, London, GB; AN 1995-070575 XP002477500 -& JP 06 346093 A (KAO CORP) 20 December 1994 (1994-12-20)

## Description

### BACKGROUND OF THE INVENTION

Numerous steps are involved in the fabrication of microelectronic structures. Within the manufacturing scheme of fabricating integrated circuits, selective etching of semiconductor surfaces is sometimes required. Historically, a number of vastly different types of etching processes, to selectively remove material have been successfully utilized to varying degrees. Moreover, the selective etching of different layers, within the microelectronic structure, is considered a critical and crucial step in the integrated circuit fabrication process.

In the manufacture of semiconductors and semiconductor microcircuits, it is frequently necessary to coat substrate materials with a polymeric organic substance. Examples of some substrate materials includes titanium, copper, silicon dioxide coated silicon wafer which may further include metallic elements such as titanium and copper. Typically, the polymeric organic substance is a photoresist material. This is a material which will form an etch mask upon development after exposure to light. In subsequent processing steps, at least a portion of the photoresist is removed from the surface of the substrate.

One common method of removing photoresist from a substrate is by wet chemical means. The wet chemical compositions formulated to remove the photoresist from the substrate should do so without corroding, dissolving, and/or dulling the surface of any metallic circuitry; chemically altering the inorganic substrate; and/or attacking the substrate itself. Another method of removing photoresist is by a dry ash method where the photoresist is removed by plasma aching using either oxygen or forming gas such as hydrogen. The residues or by-products may be the photoresist itself or a combination of the photoresist, underlying substrate and/or etch gases. These residues or by-products are often referred to as sidewall polymers, veils or fences.

The purpose of stripping and/or cleaning compositions is to remove these residues or by-products from the surface of the substrate of the semiconductor device without corroding, dissolving or dulling the exposed surface of the substrate, after the termination of the etching step.

The use of acetals as casting solvents for blends for film casting has been described. Wanat et al (US 6,911,293 B2) described a photoresist composition comprising a film forming resin, photoactive compound or photoacid generator and organic solvent selected from a list of acetals and ketals. However, the Wanat invention does not teach the use of acetal solvents as a stripping and/or cleaning composition.

Ikemoto and Kojiro (US 2004/0009883 A1) describe a resist stripping formulation that contains a fluorine compound, a mixed solvent of an amide solvent and an ether solvent and water. Examples shown are containing diethlene glycol monomethyl ether, N,N-dimethylacetamide (DMAC), ammonium fluoride and water. Dioxolane and trioxane were included in the examples of ether solvents provided in the description of the invention.

Doyle et al (US 6,689,734 B2) described cleaning formulations that have additions of some agents to the mono brominated hydrocarbon compounds with highly fluorinated compounds. Those agents are one or more of the following materials: alcohols, esters, ethers, cyclic ethers, ketones, alkanes, terpenes, dibasic esters, glycol ethers, pyrollidones, or low or non ozone depleting chlorinated and chlorinated/fluorinated hydrocarbons. 1,4 dioxane and 1,3 dioxolane were among the cyclic ether group for the agents.

### BRIEF SUMMARY OF THE INVENTION

The formulation disclosed in the present invention is capable of removing post-etched organic and inorganic residue and photoresist from semiconductor substrates.

In one respect, the present invention provides a formulation for removing post-etched organic and inorganic residue and photoresist from semiconductor substrates, comprising: an acetal or a ketal solvent, water, a polyhydric alcohol, and a pH adjuster to adjust the formulation having a pH at least 7 or higher.

In another respect, the present invention provides a method for removing post-etched organic and inorganic residue and photoresist from semiconductor substrates, comprising: contacting the substrate with a formulation comprising an acetal or a ketal solvent, water, a polyhydric alcohol, and a base, the formulation having a pH at least 7 or higher.

### DETAILED DESCRIPTION OF THE INVENTION

The present invention provides a composition whose components are present in amounts that effectively remove residue from a substrate such as, for example, a semiconductor substrate. In applications concerning semiconductor substrates, such residues include, for example, photoresists (hardened or otherwise), gap fill, bottom antireflective coating (BARC) and other polymeric materials (*e.g.*, C-F-containing polymers, low and high molecular weight polymers) and/or processing residues such as the residues generated by etching and ashing processes, inorganic compounds such as metal oxides, ceramic particles from chemical mechanical planarization (CMP) slurries and other inorganic etch residues, metal containing compounds such as, for example, organometallic residues and metal organic compounds. In one embodiment, compositions according to the present invention are particularly effective at removing silicon-containing BARC residues from a semiconductor substrate.

The residues are typically present in a substrate that may include metal, silicon, silicate and/or interlevel dielectric materials such as, for example, deposited silicon oxides and derivatized silicon oxides such as HSQ, MSQ, FOX, TEOS and spin-on glass, chemical vapor deposited dielectric materials, low-k materials and/or high-k materials such as hafnium silicate, hafnium oxide, barium strontium titanate (BST), TiO₂, TaO₅, wherein both the residues and the metal, silicon, silicide, interlevel dielectric materials, low-k and/or high-k materials will come in contact with the cleaning composition. The compositions according to the present invention are compatible with such materials and, therefore, can be employed to selectively remove residues such as, for example, those described above, without significantly attacking the metal, silicon, silicon dioxide, interlevel dielectric materials, low-k and/or high-k materials. In certain embodiments, the substrate may contain a metal, such as, but not limited to, copper, cobalt, copper alloy, titanium, titanium nitride, tantalum, tantalum nitride, tungsten, and/or titanium/tungsten alloys.

This invention describes a formulation comprising an acetal or ketal as a solvent, water, a polyhydric alcohol and a pH adjuster to adjust the formulations having a pH at least 7 or higher. Formulations in this invention can optionally contain watersoluble organic solvents as co-solvent. The formulations in this invention can be used to remove post-etched organic and inorganic residue as well as polymeric residues from semiconductor substrates.

This invention describes formulations with compositions containing an acetal or a ketal preferably with general formula I or II or the combination of both: 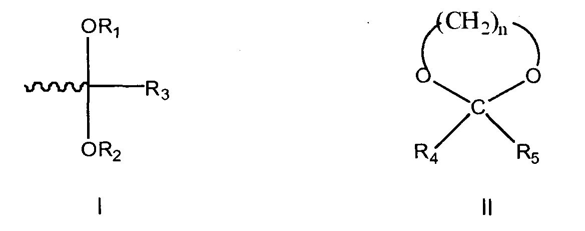 Where n ≥ 1 and R₁, R₂, R₃, R₄ and R₅ are each independently H, alkyl, or phenyl

More specifically, this invention describes a semi-aqueous stripping composition comprising preferably an acetal or ketal of types **I** or **II** or combinations of both, polyhydric alcohol, pH adjuster and water. The pH of the composition is at least 7 or higher.

In this formulation, the range of the acetal or ketal solvent is 0.01 % to 90.00 % by weight, the range of the polyol is 1% to 80% by weight, the range of the water is 1% to 80% by weight, and the range of pH adjuster is 0.1 to 50% by weight. The preferred range of the acetal or ketal solvent is 5 % to 55.00 % by weight, the range of the polyol is 3% to 40% by weight, the range of the water is 5% to 60% by weight, and the range of pH adjuster is 0.1 to 15% by weight.

Preferred acetal or ketal solvents for such formulations are tetramethoxypropane, tetramethoxyethane, malonaldehyde bis(methyl acetal), phenylacetaldehyde dimethyl acetal, benzaldehyde dimethyl acetal, phenylacetaldehyde ethylene acetal, chloroacetaldehyde dimethyl acetal, Chloroacetaldehyde diethyl acetal, 1,3-dioxolane, trioxane, and mixtures thereof.

Preferred polyhydric alcohols for such formulations are ethylene glycol, propylene glycol, glycerol, butanediol, pentanediol and mixtures thereof.

Preferred pH adjusters for such formulations are Tetrabutylammonium hydroxide (TBAH), Tetramethylammonium hydroxide (TMAH), Potassium hydroxide (KOH), Benzyltrimethylammonium hydroxide (BzTMAH). The pH adjuster also functions to assist in the removal of organic and inorganic residues.

Non-limiting examples of water include deionized (DI) water, ultra pure water, distilled water, doubly distilled water, or deionized water having a low metal content. Preferably, the water in the composition comprises DI water. In the present invention, water functions in various ways such as, for example, as a solvent to dissolve one or more solid components of the composition, as a carrier of the components, as an aid in the removal of the residue, as a viscosity modifier of the composition, and as a diluent.

Formulations in these compositions can also contain other organic solvents as co-solvents. The organic solvent may be selected from Tetrahydrofurfuryl alcohol, a glycol ether, and mixtures thereof. These formulations are restricted to cases where pH is at least 7 or higher.

The formulations in this invention can contain ammonium and quaternary ammonium fluoride. If employed, the ammonium and quaternary ammonium fluoride functions to assist in the removal of organic and inorganic residues. Preferred ammonium and quaternary ammonium fluoride are Tetrabutylammonium fluoride, Tetrapropylammonium hydroxide, Tetraethylammonium hydroxide, Tetramethylammonium fluoride, Ammonium hydroxide, and mixtures thereof. These formulations are restricted to cases where pH is at least 7 or higher.

The use of a corrosion inhibitor is optional in this invention. Examples of the corrosion inhibitor are tolyltriazole, benzotriazole, catechol, gallic acid and mixtures thereof. These formulations are restricted to cases where pH is at least 7 or higher.

Formulations containing the acetals or ketals have proved to be effective in removal of both pre- and post-etched photoresist, etched residues and post-etch polymeric residues. Care was taken to be sure that pH of the composition was at least 7 or higher as compositions with pH lower than 7 could pose shelf-life issues.

The cleaning composition of the present invention is typically prepared by mixing the components together in a vessel at room temperature until all solids have dissolved in the aqueous-based medium.

Compositions disclosed herein are compatible with substrates containing low-k films such as HSQ (FOx), MSQ, SiLK, etc. including those low-k films containing a fluoride. The compositions are also effective in stripping photoresists including positive and negative photoresists and plasma etch residues such as organic residues, organometallic residues, inorganic residues, metallic oxides, or photoresist complexes at low temperatures with very low corrosion of copper, and/or titanium containing substrates. Moreover, the compositions are compatible with a variety of metal, silicon, silicon dioxide, interlevel dielectric materials, low-k and/or high-k materials.

During the manufacturing process, a photoresist layer is coated on the substrate. Using a photolithographic process, a pattern is defined on the photoresist layer. The thus patterned photoresist layer is subjected to plasma etch by which the pattern is transferred to the substrate. Etch residues are generated in the etch stage. Some of the substrates used in this invention are ashed while some are not ashed. When the substrates are ashed, the main residues to be cleaned are etchant residues. If the substrates are not ashed, then the main residues to be cleaned or stripped are both etch residues and photoresists.

The method described herein may be conducted by contacting a substrate having a metal, organic or metal-organic polymer, inorganic salt, oxide, hydroxide, or complex or combination thereof present as a film or residue, with the described composition. The actual conditions, *e.g.*, temperature, time, etc., depend on the nature and the thickness of the material to be removed. In general, the substrate is contacted or dipped into a vessel containing the composition at a temperature ranging from 20°C to 85°C, or from 20°C to 60°C, or from 20°C and 40°C. Typical time periods for exposure of the substrate to the composition may range from, for example, 0.1 to 60 minutes, or 1 to 30 minutes, or 1 to 15 minutes. After contact with the composition, the substrate may be rinsed and then dried. Drying is typically carried out under an inert atmosphere. In certain embodiments, a deionized water rinse or rinse containing deionized water with other additives may be employed before, during, and/or after contacting the substrate with the composition described herein. However, the composition can be used in any method known in the art that utilizes a cleaning fluid for the removal of photoresist, ash or etch residues and/or residues.

It will be appreciated by those skilled in the art that the composition may be modified to achieve optimum cleaning without damaging the substrate so that high throughput cleaning can be maintained in the manufacturing process. For example, one skilled in the art would appreciate that, for example, modifications to the amounts of some or all of the components may be made depending upon the composition of the substrate being cleaned, the nature of the residue to be removed, and the particular process parameters used.

Although the present invention has been principally described in connection with cleaning semiconductor substrates, the cleaning compositions of the invention can be employed to clean any substrate that includes organic and inorganic residues.

The following examples are provided for the purpose of further illustrating the present invention but are by no means intended to limit the same.

### EXAMPLES

In the following examples, all amounts are given in weight percent and add up to 100 weight percent. The compositions disclosed herein were prepared by mixing the components together in a vessel at room temperature until all solids have dissolved. Examples of certain compositions disclosed herein are set forth in Table I.

The following are the acronyms used in Table I:

| | | | |
|---|---|---|---|
| TME | Tetramethoxyethane | t-PGME | Tripropylene glycol methyl ether |
| PG | Propylene glycol | BZT | Benzotriazole |
| TTL | Tolyltriazole | TBAH | Tetrabutylammonium hydroxide |
| TBAF | Tetrabutylammonium fluoride | TMAH | Tetramethylammonium hydroxide |
| TMAF | Tetramethylammonium fluoride | TMP | Tetramethoxypropane |
| THFA | Tetrahydrofurfuryl alcohol | | (aka malonaldehyde bis(methyl acetal) |
| KOH | Potassium hydroxide | BzTMAH | Benzyltrimethylammonium hydroxide |
| BzDMA | Benzaldehyde dimethyl acetal | PADMA | Phenylacetaldehyde dimethyl acetal |
| CADMA | Chloroacetaldehyde dimethyl acetal | CADEA | Chloroacetaldehyde diethyl acetal |
| PGME | Propylene glycol methyl ether | DPM | Dipropylene glycol methyl ether |

**Table I: EXEMPLARY COMPOSITIONS**

| ***Example A*** | | ***Example B*** | | ***Example C*** | |
|---|---|---|---|---|---|
| TME | 29.0 | DI Water | 10.0 | THFA | 48.0 |
| DI Water | 33.5 | TMAF (20%) | 0.8 | TME | 9.0 |
| TMAF (20%) | 1.5 | Aniline-2-sulfonic acid | 0.5 | KOH (45%) | 0.0 |
| PG | 12.0 | TMAH (25%) | 0.0 | TMAH (25%) | 6.0 |
| BZT | 2.0 | BZT | 1.8 | TTL | 1.5 |
| aniline-2-sulfonic acid | 2.0 | PG | 0.0 | PG | 6.5 |
| TMAH (25%) | 20.0 | Guanidine carbonate | 0.0 | benzyl alcohol | 10.0 |
| | | TME | 86.9 | Dl Water | 19.0 |
| | | | | | |

| ***Example D*** | | ***Example E*** | | ***Example F*** | |
|---|---|---|---|---|---|
| THFA | 30.0 | DI Water | 30.0 | DI Water | 46.0 |
| TMP | 10.0 | TMAF (20%) | 0.8 | TMAF (20%) | 0.8 |
| KOH (45%) | 0.0 | Aniline-2-sulfonic acid | 0.5 | Aniline-2-sulfonic acid | 0.5 |
| TBAH (55%) | 30.0 | TMAH (25%) | 20.0 | TMAH (25%) | 30.0 |
| TTL | 3.0 | BZT | 1.8 | BZT | 1.8 |
| PG | 6.5 | PG | 5.0 | PG | 5.0 |
| tetrahydronaphthalene | 0.0 | Guanidine carbonate | 10.0 | Guanidine carbonate | 10.0 |
| Dl Water | 20.5 | TME | 31.9 | TME | 5.9 |
| | | | | | |

| ***Example G*** | | ***Example H*** | | ***Example I*** | |
|---|---|---|---|---|---|
| TME | 20.0 | TME | 20.0 | THFA | 30.0 |
| TMAF (20%) | 0.8 | TMAF (20%) | 0.8 | TMP | 10.0 |
| Aniline-2-sulfonic acid | 0.5 | Aniline-2-sulfonic acid | 0.5 | KOH (45%) | 0.0 |
| TMAH (25%) | 25.0 | TMAH (25%) | 25.0 | TBAH (55%) | 30.0 |
| BZT | 1.8 | BZT | 1.8 | TTL | 3.0 |
| PG | 5.0 | PG | 5.0 | PG | 6.5 |
| Guanidine carbonate | 8.0 | Guanidine carbonate | 12.0 | DI Water | 20.5 |
| DI Water | 38.9 | DI Water | 34.9 | | |
| | | | | | |

| ***Example J*** | | ***Example K*** | | ***Example L*** | |
|---|---|---|---|---|---|
| THFA | 30.0 | THFA | 40.0 | THFA | 50.0 |
| TMP | 10.0 | TMP | 10.0 | TMP | 15.0 |
| KOH (45%) | 0.0 | KOH (45%) | 0.0 | KOH (45%) | 0.0 |
| TBAH (55%) | 20.0 | TBAH (55%) | 20.0 | TBAH (55%) | 15.0 |
| TTL | 3.0 | TTL | 3.0 | TTL | 3.0 |
| PG | 6.5 | PG | 6.5 | PG | 6.5 |
| Dl Water | 30.5 | Dl Water | 20.5 | Dl Water | 10.5 |
| | | | | | |

| ***Example M*** | | ***Example N*** | | ***Example O*** | |
|---|---|---|---|---|---|
| THFA | 30.0 | THFA | 30.0 | THFA | 40.0 |
| TMP | 10.0 | TMP | 10.0 | TMP | 10.0 |
| KOH (45%) | 0.0 | KOH (45%) | 0.0 | KOH (45%) | 0.0 |
| TBAH (55%) | 35.0 | TBAH (55%) | 40.0 | TBAH (55%) | 40.0 |
| TTL | 3.0 | TTL | 3.0 | TTL | 3.0 |
| PG | 6.5 | PG | 6.5 | PG | 7.0 |
| DI Water | 15.5 | Dl Water | 10.5 | Dl Water | 0.0 |
| | | | | | |

| ***Example P*** | | ***Example Q*** | | ***Example R*** | |
|---|---|---|---|---|---|
| THFA | 40.0 | THFA | 20.0 | THFA | 30.0 |
| TMP | 15.0 | TMP | 10.0 | TMP | 10.0 |
| KOH (45%) | 0.0 | KOH (45%) | 0.0 | KOH (45%) | 0.0 |
| TBAH (55%) | 35.0 | TBAH (55%) | 20.0 | TBAH (55%) | 20.0 |
| TTL | 3.0 | TTL | 3.0 | TTL | 3.0 |
| PG | 7.0 | PG | 6.5 | PG | 6.5 |
| Dl Water | 0.0 | Dl Water | 40.5 | Dl Water | 30.5 |
| | | | | | |

| ***Example S*** | | ***Example T*** | | ***Example U*** | |
|---|---|---|---|---|---|
| THFA | 20.0 | THFA | 30.0 | THFA | 30.0 |
| TMP | 10.0 | TMP | 10.0 | TMP | 10.0 |
| KOH (45%) | 0.0 | KOH (45%) | 0.0 | KOH (45%) | 0.0 |
| TBAH (55%) | 30.0 | TBAH (55%) | 30.0 | BzTMAH (20%) | 20.0 |
| TTL | 3.0 | TTL | 3.0 | TTL | 3.0 |
| PG | 6.5 | PG | 6.5 | PG | 6.5 |
| Dl Water | 30.5 | Dl Water | 20.5 | Dl Water | 30.5 |
| | | | | | |

| ***Example V*** | | ***Example W*** | | ***Example* X** | |
|---|---|---|---|---|---|
| THFA | 30.0 | THFA | 50.0 | THFA | 50.0 |
| TMP | 10.0 | TMP | 10.0 | TMP | 10.0 |
| KOH (45%) | 0.0 | KOH (45%) | 0.0 | KOH (45%) | 0.0 |
| BzTMAH (20%) | 30.0 | TMAH (25%) | 20.0 | TBAH (55%) | 20.0 |
| TTL | 3.0 | TTL | 3.0 | TTL | 3.0 |
| PG | 6.5 | PG | 6.5 | PG | 6.5 |
| Dl Water | 20.5 | Dl Water | 10.5 | Dl Water | 10.5 |
| | | | | | |

| ***Example Y*** | | ***Example Z*** | | ***Example A1*** | |
|---|---|---|---|---|---|
| THFA | 30.0 | THFA | 30.0 | THFA | 50.0 |
| TMP | 20.0 | TMP | 15.0 | TMP | 10.0 |
| KOH (45%) | 0.0 | KOH (45%) | 0.0 | KOH (45%) | 0.0 |
| TBAH (55%) | 30.0 | TBAH (55%) | 30.0 | BzTMAH (40%) | 20.0 |
| TTL | 3.0 | TTL | 3.0 | TTL | 3.0 |
| PG | 6.5 | PG | 6.5 | PG | 6.5 |
| DI Water | 10.5 | DI Water | 15.5 | DI Water | 10.5 |
| | | | | | |

| ***Example A2*** | | ***Example A3*** | | ***Example A4*** | |
|---|---|---|---|---|---|
| THFA | 40.0 | THFA | 42.0 | THFA | 39.0 |
| TMP | 10.0 | BzDMA | 17.0 | BzDMA | 13.0 |
| KOH (45%) | 0.0 | KOH (45%) | 0.0 | KOH (45%) | 0.0 |
| TMAH (25%) | 20.0 | TBAH (55%) | 25.0 | TBAH (55%) | 26.0 |
| TTL | 3.0 | TTL | 2.5 | TTL | 2.6 |
| PG | 6.5 | PG | 5.4 | PG | 5.7 |
| DI Water | 20.5 | DI Water | 8.1 | DI Water | 13.7 |
| | | | | | |

| ***Example A5*** | | ***Example A6*** | | ***Example A7*** | |
|---|---|---|---|---|---|
| THFA | 30.0 | THFA | 42.0 | THFA | 38.0 |
| TMP | 20.0 | TME | 12.0 | PADMA | 18.0 |
| TBAF (75%) | 2.0 | KOH (45%) | 0.0 | KOH (45%) | 0.0 |
| TBAH (55%) | 28.0 | TMAH (25%) | 15.0 | TBAH (55%) | 27.0 |
| TTL | 3.0 | TTL | 5.0 | TTL | 2.6 |
| PG | 6.5 | PG | 9.0 | PG | 5.8 |
| DI Water | 10.5 | 1-chloronaphthalene | 4.0 | DI Water | 8.6 |
| | | DI Water | 13.0 | | |

| ***Example A8*** | | ***Example A9*** | | ***Example A10*** | |
|---|---|---|---|---|---|
| THFA | 36.0 | THFA | 30.0 | THFA | 30.0 |
| PADMA | 14.0 | TMP | 14.0 | TMP | 10.0 |
| KOH (45%) | 0.0 | CADMA | 6.0 | CADMA | 10.0 |
| TBAH (55%) | 28.0 | TBAH (55%) | 28.0 | TBAH (55%) | 28.0 |
| TTL | 2.8 | TTL | 2.8 | TTL | 2.8 |
| PG | 6.0 | PG | 6.0 | PG | 6.0 |
| DI Water | 13.2 | DI Water | 13.2 | DI Water | 13.2 |
| | | | | | |

| ***Example A11*** | | ***Example A12*** | | ***Example A13*** | |
|---|---|---|---|---|---|
| THFA | 30.0 | THFA | 30.0 | THFA | 30.0 |
| TMP | 14.0 | TMP | 14.0 | TMP | 14.0 |
| CADEA | 2.0 | CADEA | 2.0 | CADEA | 6.0 |
| TBAH (55%) | 14.0 | TBAH (55%) | 20.0 | TBAH (55%) | 28.0 |
| TTL | 2.8 | TTL | 2.8 | TTL | 2.8 |
| PG | 6.0 | PG | 6.0 | PG | 6.0 |
| TMAH (25%) | 14.0 | BzTMAH | 2.0 | | |
| Dl Water | 17.2 | Dl Water | 23.2 | Dl Water | 13.2 |
| | | | | | |

| ***Example A14*** | | ***Example A15*** | | ***Example A16*** | |
|---|---|---|---|---|---|
| THFA | 58.0 | THFA | 30.0 | THFA | 30.0 |
| TME | 9.0 | TMP | 14.0 | TMP | 14.0 |
| KOH (45%) | 0.0 | CADMA | 6.0 | CADMA | 6.0 |
| TMAH (25%) | 15.0 | TBAH (55%) | 14.0 | TBAH (55%) | 20.0 |
| TTL | 1.5 | TTL | 2.8 | TTL | 2.8 |
| PG | 6.5 | PG | 6.0 | PG | 6.0 |
| tetrahydronaphthalene | 4.0 | TMAH | 14.0 | BzTMAH | 2.0 |
| DI Water | 6.0 | DI Water | 13.2 | DI Water | 19.2 |
| | | | | | |

| ***Example A17*** | | ***Example A18*** | | ***Example A19*** | |
|---|---|---|---|---|---|
| THFA | 34.0 | THFA | 35.5 | THFA | 30.0 |
| TMP | 19.0 | TMP | 18.0 | TMP | 14.0 |
| TMAF (20%) | 0.0 | TMAF (20%) | 1.0 | CADMA | 6.0 |
| TMAH (25%) | 27.0 | TMAH (25%) | 26.0 | TBAH (55%) | 5.0 |
| TTL | 3.0 | TTL | 3.0 | TTL | 2.8 |
| PG | 6.5 | PG | 6.0 | PG | 6.0 |
| tetrahydronaphthalene | 0.0 | tetrahydronaphthalene | 0.0 | TMAH | 20.0 |
| DI Water | 10.5 | DI Water | 10.5 | DI Water | 16.2 |
| | | | | | |

| ***Example A20*** | | ***Example A21*** | | ***Example A22*** | |
|---|---|---|---|---|---|
| THFA | 30.0 | THFA | 34.0 | THFA | 36.0 |
| TMP | 14.0 | TMP | 19.0 | TMP | 18.0 |
| CADMA | 6.0 | TMAF (20%) | 2.0 | TMAF (20%) | 4.0 |
| TBAH (55%) | 15.0 | TMAH (25%) | 26.0 | TMAH (25%) | 26.0 |
| TTL | 2.8 | TTL | 3.0 | TTL | 3.0 |
| PG | 6.0 | PG | 6.0 | PG | 6.0 |
| BzTMAH | 2.0 | tetrahydronaphthalene | 0.0 | tetrahydronaphthalene | 0.0 |
| Dl Water | 24.2 | Dl Water | 10.0 | Dl Water | 7.0 |
| | | | | | |

| ***Example A23*** | | ***Example A24*** | | ***Example A25*** | |
|---|---|---|---|---|---|
| THFA | 30.0 | THFA | 40.0 | THFA | 30.0 |
| TMP | 14.0 | TMP | 14.0 | TMP | 14.0 |
| CADEA | 2.0 | CADEA | 2.0 | CADEA | 2.0 |
| TBAH (55%) | 20.0 | TMAH (25%) | 10.0 | TMAH (25%) | 20.0 |
| TTL | 2.8 | TTL | 2.8 | TTL | 2.8 |
| PG | 6.0 | PG | 6.0 | PG | 6.0 |
| BzTMAH | 2.0 | BzTMAH | 2.0 | BzTMAH | 2.0 |
| DI Water | 23.2 | DI Water | 23.2 | DI Water | 23.2 |
| | | | | | |

| ***Example A26*** | | ***Example A27*** | | ***Example A28*** | |
|---|---|---|---|---|---|
| DPM | 30.0 | TPM | 30.0 | PGME | 40.0 |
| TMP | 14.0 | TMP | 14.0 | TMP | 14.0 |
| CADEA | 2.0 | CADEA | 2.0 | CADEA | 2.0 |
| TMAH (25%) | 20.0 | TBAH (55%) | 20.0 | TMAH (25%) | 10.0 |
| TTL | 2.8 | TTL | 2.8 | TTL | 2.8 |
| PG | 6.0 | PG | 6.0 | PG | 6.0 |
| BzTMAH | 2.0 | BzTMAH | 2.0 | BzTMAH | 2.0 |
| DI Water | 23.2 | DI Water | 23.2 | DI Water | 23.2 |
| | | | | | |

| ***Example A29*** | | ***Example A30*** | | ***Example A31*** | |
|---|---|---|---|---|---|
| Sulfolane | 30.0 | THFA | 30.0 | DPM | 30.0 |
| TMP | 14.0 | 1,3-dioxolane | 14.0 | 1,3-dioxolane | 16.0 |
| CADEA | 2.0 | CADEA | 2.0 | CADEA | 0 |
| TMAH (25%) | 20.0 | TMAH (25%) | 20.0 | TMAH (25%) | 20.0 |
| TTL | 2.8 | TTL | 2.8 | TTL | 2.8 |
| PG | 6.0 | PG | 6.0 | PG | 6.0 |
| BzTMAH | 2.0 | BzTMAH | 2.0 | BzTMAH | 2.0 |
| DI Water | 23.2 | DI Water | 23.2 | DI Water | 23.2 |

| | | | | | |
|---|---|---|---|---|---|
| ***Example A32*** | | ***Example A33*** | | ***Example A34*** | |
| THFA | 39.0 | TME | 30 | PGME | 30 |
| PADMA | 13.0 | DI Water | 36 | DI Water | 36 |
| KOH (45%) | 0.0 | PG | 10 | PG | 10 |
| TBAH (55%) | 26.0 | BZT | 2 | BZT | 2 |
| TTL | 2.6 | aniline-2-sulfonic acid | 2 | aniline-2-sulfonic acid | 2 |
| PG | 5.7 | TMAH (25%) | 20 | TMAH (25%) | 20 |
| DI Water | 13.7 | | | | |
| | | | | | |

| ***Example A35*** | | | | | |
|---|---|---|---|---|---|
| TME | 15 | | | | |
| Dl Water | 36 | | | | |
| PGME | 15 | | | | |
| PG | 10 | | | | |
| BZT | 2 | | | | |
| aniline-2-sulfonic acid | 2 | | | | |
| TMAH (25%) | 20 | | | | |

### Compositions of the Substrate

Each substrate used in the present Examples comprised three layers. The first (i.e., the bottom layer) was an inter level dielectric (ILD) material comprising BLACK DIAMOND II^{™}. The next layer was a silicon-containing bottom antireflective coating (BARC) (193 nm) and the top layer was a photoresist (193 nm). The substrates were then subjected to plasma etching

### Processing Conditions

Cleaning tests were run using 305 mL of the cleaning compositions in a 400mL beaker with a ½" (1.25 cm) round Teflon^{™} stir bar set at 600 rpm. The cleaning compositions were heated to the desired temperature indicated below on a hot plate if necessary. Wafer segments approximately ½" x ½" (1.25 x 1.25 cm) in size were immersed in the compositions under the following set of conditions.
10 minutes @ 25°C
20 minutes @ 25°C
10 minutes @ 35°C
20 minutes @ 35°C
The segments were then rinsed for 3 minutes in a DI water overflow bath and subsequently dried using filtered nitrogen. They were then analyzed for cleanliness using SEM microscopy.

**Table II: Cleaning Data**

| **Formulations** | **BARC** | | **Photo-resist** | |
|---|---|---|---|---|
| | **248 nm** | **193 nm** | **248 nm** | **193 nm** |
| Example A | √ | √- | √ | X |
| Example B | √- | X | √ | X |
| Example C | √- | X | √ | X |
| Example D | √ | X | √ | √- |
| Example E | √ | √ | √ | √- |
| Example F | √ | √- | √ | √- |
| Example G | √ | √- | √ | √- |
| Example H | √ | √- | √ | √- |
| Example I | √ | X | √ | √ |
| Example J | √ | √- | √ | √ |
| Example K | √ | √- | √ | √ |
| Example L | √ | √ | √ | √ |
| Example M | √ | √- | √ | √ |
| Example N | √ | √- | √ | √ |
| Example O | √- | √- | √ | √- |
| Example P | √ | X | √ | √- |
| Example Q | √ | √- | √ | √ |
| Example R | √ | X | √ | √ |
| Example S | √ | √- | √ | √- |
| Example T | √ | √ | √ | √ |
| Example U | √ | √ | √ | √- |
| Example V | √ | √- | √ | √ |
| Example W | √ | √ | √ | √ |
| Example X | √ | √ | √ | √ |
| Example Y | √ | √ | √ | √ |
| Example Z | √ | X | √ | X |
| Example A1 | √ | √ | √ | √ |
| Example A2 | √ | √ | √ | √ |
| Example A3 | √ | √ | √ | √ |
| Example A4 | √ | √ | √ | √ |
| Example A5 | √ | √- | √ | √ |
| Example A6 | √ | √- | √ | √- |
| Example A7 | √ | √- | √ | √- |
| Example A8 | √ | X | √ | √- |
| Example A9 | √ | √- | √ | √ |
| Example A10 | √ | √- | √ | √ |
| Example A11 | √ | √- | √ | √- |
| Example A12 | √ | √- | √ | √ |
| Example A13 | √ | √- | √ | √- |
| Example A14 | √ | √- | √ | √ |
| Example A15 | √ | √- | √ | √- |
| Example A16 | √ | √ | √ | √ |
| Example A17 | √ | √- | √ | √- |
| Example A18 | √ | √- | √ | √ |
| Example A19 | √ | √ | √ | √- |
| Example A20 | √ | √- | √- | √- |
| Example A21 | √ | √ | √- | √ |
| Example A22 | √ | √ | √ | √- |
| Example A23 | √ | √ | √ | √- |
| Example A24 | √ | √ | √ | √- |
| Example A25 | √ | √- | √- | √- |
| Example A26 | √ | √- | NT | √- |
| Example A27 | NT | √ | NT | √ |
| Example A28 | NT | √ | NT | √- |
| Example A29 | NT | √ | NT | √ |
| Example A30 | NT | √ | NT | √ |
| Example A31 | NT | √ | NT | √ |
| Example A32 | NT | √ | NT | √ |
| Example A33 | NT | √ | NT | √ |
| Example A34 | NT | X | NT | √- |
| Example A35 | NT | √- | NT | √- |

| | | | | |
|---|---|---|---|---|
| √ = successful √- = partially successful **X** = unsuccessful **NT** = not tested | | | | |

Table II illustrates the effectiveness of compositions according to the present invention at removing a BARC residue and a photoresist residue.

### Etch Rate Measurement Procedure

Coupons of blanket Cu, Co, and W wafers were measured for metal layer thickness by measuring the resistivity of the layer by employing a ResMap^{™} model 273 resistivity instrument from Creative Design Engineering, Inc. The coupons were then immersed in the composition at the desired temperature for up to one hour. Periodically the coupons were removed from the composition, rinsed with de-ionized water and dried and the thickness of the metal layer was again measured. A graph of the change in thickness as a function of immersion time was made and the etch rate in Angstroms(0.1 nm)/min was determined from the slope of the curve.

**Table III: Cleaning and Etching Data**

| **Formulations** | **BARC** | **Cu** | **Co** | **W** |
|---|---|---|---|---|
| | **193 nm (Å/min)** | **(Å/min)** | **(Å/min)** | **(Å/min)** |
| Example J | 379 | 23 | 51 | NT |
| Example P | 2 | 4 | NT | 0 |
| Example Y | 187 | 10 | NT | NT |
| Example A2 | 381 | <1 | <2 | ∼1 |
| Example A26 | 18 | 4 | NT | NT |
| Example A31 | 13 | 9 | NT | NT |

| | | | | |
|---|---|---|---|---|
| NT = not tested | | | | |

Table III illustrates the effectiveness of certain of the compositions according to the present invention at selectively removing residue without significantly etching the metal substrate.

The foregoing examples and description of the preferred embodiments should be taken as illustrating, rather than as limiting the present invention as defined by the claims. As will be readily appreciated, numerous variations and combinations of the features set forth above can be utilized without departing from the present invention as set forth in the claims.

## Claims

1. A formulation to remove post-etched organic and inorganic residue and photoresist from semiconductor substrates, comprising:
an acetal or a ketal solvent;
water;
a polyhydric alcohol; and
a pH adjuster;
the formulation having a pH of 7 or higher.

2. The formulation of Claim 1 wherein the acetal or the ketal solvent having a formula selected from formula I, formula II and combinations thereof: 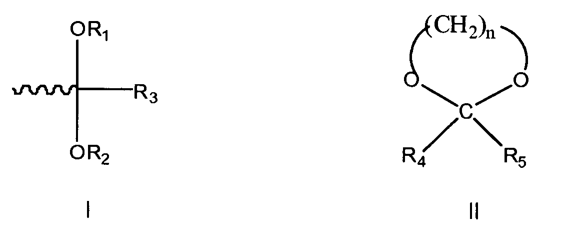 wherein n ≥ 1 and R₁, R₂, R₃, R₄ and R₅ are each independently H, alkyl (including heteroalkyl), or aryl.

3. The formulation of any preceding claim wherein the acetal or the ketal solvent is selected from tetramethoxypropane, tetramethoxyethane, malonaldehyde bis(methyl acetal), phenylacetaldehyde dimethyl acetal, benzyladehyde dimethyl acetal, phenylacetaldehyde ethylene acetal, chloroacetaldehyde dimethyl acetal, chloroacetaldehyde diethyl acetal, 1,3-dioxolane, trioxane, and mixtures thereof.

4. The formulation of any preceding claim wherein the polyhydric alcohol is selected from ethylene glycol, propylene glycol, glycerol, butanediol, pentanediol and mixtures thereof.

5. The formulation of any preceding claim wherein the pH adjuster is selected from Tetrabutylammonium hydroxide, Tetramethylammonium hydroxide, Potassium hydroxide, Benzyltrimethylammonium hydroxide, and mixtures thereof.

6. The formulation of any preceding claim wherein, relative to the total weight of the composition, the acetal or the ketal solvent is present in an amount of 0.01 % to 90 % by weight; the polyhydric alcohol is present in an amount of 1% to 80% by weight; the water is present in an amount of 1% to 80% by weight; and the pH adjuster is present in an amount of 0.1% to 50% by weight.

7. The formulation of Claim 6 wherein, relative to the total weight of the composition, the acetal or the ketal solvent is present in an amount of 5% to 55% by weight, the polyhydric alcohol is present in an amount of 3% to 40% by weight, the water is present in an amount of 5% to 60% by weight, and the pH adjuster is present in an amount of 0.1% to 15% by weight.

8. The formulation of any preceding claim comprising ammonium and quaternary ammonium fluoride.

9. The formulation of Claim 8 wherein the ammonium and quaternary ammonium fluoride is selected from Tetrabutylammonium fluoride, Tetrapropylammonium hydroxide, Tetraethylammonium hydroxide, Tetramethylammonium fluoride, Ammonium hydroxide, and mixtures thereof.

10. The formulation of any preceding claim further comprising a corrosion inhibitor.

11. The formulation of Claim 10 wherein the corrosion inhibitor is selected from tolyltriazole, benzotriazole, catechol, gallic acid and mixtures thereof.

12. The formulation of any preceding claim further comprising an organic solvent.

13. The formulation of Claim 12 wherein the organic solvent is selected from Tetrahydrofurfuryl alcohol, Propylene ether, and mixtures thereof.

14. A method for removing post-etched organic and inorganic residue and photoresist from semiconductor substrates, comprising; contacting the substrate with a formulation comprising an acetal or ketal solvent, a pH adjuster, water and a polyhydric alcohol, the formulation having a pH of 7 or higher.

15. The method of claim 14, wherein the formulation is as further defined in any one of claims 1 to 13.

## Patentansprüche

1. Formulierung zum Entfernen eines organischen und anorganischen Rückstands und eines Photoresists von Halbleitersubstraten nach dem Ätzen, umfassend:
ein Lösungsmittel in Form von Acetal oder Ketal;
Wasser;
einen mehrwertigen Alkohol; und
ein Mittel zur Regelung des pH-Wertes;
wobei die Formulierung einen pH-Wert von 7 oder mehr aufweist.

2. Formulierung nach Anspruch 1, wobei das Lösungsmittel in Form von Acetal oder Ketal eine Formel aufweist, die aus der Formel I, der Formel II und Kombinationen davon ausgewählt ist: 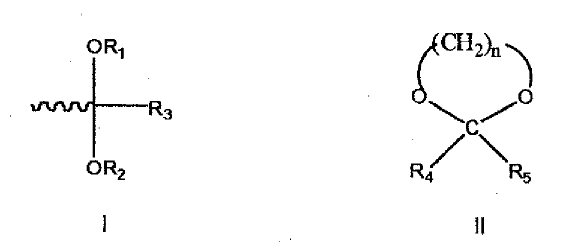 worin n ≥ 1 ist und R₁, R₂, R₃, R₄ und R₅ jeweils unabhängig voneinander H, Alkyl (einschließlich Heteroalkyl) oder Aryl sind.

3. Formulierung nach einem der vorstehenden Ansprüche, wobei das Lösungsmittel in Form von Acetal oder Ketal ausgewählt ist aus Tetramethoxypropan, Tetramethoxyethan, Malonaldehydbis(me-thylacetal), Phenylacetaldehyddimethylacetal, Benzylaldehyddimethylacetal, Phenylacetaldehydethylenacetal, Chloracetaldehyddimethylacetal, Chloracetaldehyddiethylacetal, 1,3-Dioxolan, Trioxan und Gemischen davon.

4. Formulierung nach einem der vorstehenden Ansprüche, wobei der mehrwertige Alkohol aus Ethylenglycol, Propylenglycol, Glycerol, Butandiol, Pentandiol und Gemischen davon ausgewählt ist.

5. Formulierung nach einem der vorstehenden Ansprüche, wobei das Mittel zur Regelung des pH-Wertes aus Tetrabutylammoniumhydroxid, Tetramethylammoniumhydroxid, Kaliumhydroxid, Benzyltrimethylammoniumhydroxid und Gemischen davon ausgewählt ist.

6. Formulierung nach einem der vorstehenden Ansprüche, wobei, bezogen auf das Gesamtgewicht der Zusammensetzung, das Lösungsmittel in Form von Acetal oder Ketal in einer Menge von 0,01 bis 90 Gew.-% vorliegt, der mehrwertige Alkohol in einer Menge von 1 bis 80 Gew.-% vorliegt, das Wasser in einer Menge von 1 bis 80 Gew.-% vorliegt, und das Mittel zur Regelung des pH-Wertes in einer Menge von 0,1 bis 50 Gew.-% vorliegt.

7. Formulierung nach Anspruch 6, wobei, bezogen auf das Gesamtgewicht der Zusammensetzung, das Lösungsmittel in Form von Acetal oder Ketal in einer Menge von 5 bis 55 Gew.-% vorliegt, der mehrwertige Alkohol in einer Menge von 3 bis 40 Gew.-% vorliegt, das Wasser in einer Menge von 5 bis 60 Gew.-% vorliegt, und das Mittel zur Regelung des pH-Wertes in einer Menge von 0,1 bis 15 Gew.-% vorliegt.

8. Formulierung nach einem der vorstehenden Ansprüche, die Ammonium und quaternäres Ammoniumfluorid aufweist.

9. Formulierung nach Anspruch 8, wobei das Ammonium und quaternäre Ammoniumfluorid ausgewählt ist aus Tetrabutylammoniumfluorid, Tetrapropylammoniumhydroxid, Tetraethylammoniumhydroxid, Tetramethylammoniumfluorid, Ammoniumhydroxid und Gemischen davon.

10. Formulierung nach einem der vorstehenden Ansprüche, die ferner einen Korrosionsinhibitor aufweist.

11. Formulierung nach Anspruch 10, wobei der Korrosionsinhibitor aus Tolyltriazol, Benzotriazol, Catechin, Gallsäure und Gemischen davon ausgewählt ist.

12. Formulierung nach einem der vorstehenden Ansprüche, die ferner ein organisches Lösungsmittel umfaßt.

13. Formulierung nach Anspruch 12, wobei das organische Lösungsmittel aus Tetrahydrofurfurylalkohol, Propylenether und Gemischen davon ausgewählt ist.

14. Verfahren zum Entfernen einen organischen und anorganischen Rückstandes und eines Photoresists von Halbleitersubstraten nach dem Ätzen, das folgendes aufweist: Inkontaktbringen des Substrats mit einer Formulierung, die ein Lösungsmittel in Form von Acetal oder Ketal, ein Mittel zur Regelung des pH-Wertes, Wasser und einen mehrwertigen Alkohol umfaßt, wobei die Formulierung einen pH-Wert von 7 oder mehr aufweist.

15. Verfahren nach Anspruch 14, wobei die Formulierung wie in einem der Ansprüche 1 bis 13 weiterhin angegeben ist.

## Revendications

1. Formulation pour retirer un résidu organique et inorganique et un photorésist de substrats semi-conducteurs après la gravure, comprenant :
un solvant acétal ou cétal ;
de l'eau ;
un alcool polyhydroxylé ; et
un agent d'ajustement du pH ;
la formulation ayant un pH de 7 ou supérieur.

2. Formulation selon la revendication 1 où le solvant acétal ou cétal ayant une formule choisie parmi la formule I, la formule II et leurs combinaisons : 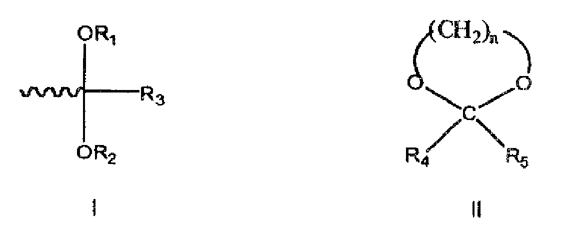 où n ≥ 1 et R₁, R₂, R₃, R₄ et R₅ sont chacun indépendamment H, alkyle (incluant hétéroalkyle) ou aryle.

3. Formulation selon l'une quelconque des revendications précédentes où le solvant acétal ou cétal est choisi parmi le tétraméthoxypropane, le tétraméthoxyéthane, le malonaldéhyde-bis(méthylacétal), le phénylacétaldéhyde-diméthylacétal, le benzaldéhyde-diméthylacétal, le phénylacétaldéhyde-éthylène-acétal, le chloroacétaldéhyde-diméthylacétal, le chloroacétaldéhyde-diéthylacétal, le 1,3-dioxolane, le trioxane et leurs mélanges.

4. Formulation selon l'une quelconque des revendications précédentes où l'alcool polyhydroxylé est choisi parmi l'éthylèneglycol, le propylèneglycol, le glycérol, le butanediol, le pentanediol et leurs mélanges.

5. Formulation selon l'une quelconque des revendications précédentes où l'agent d'ajustement du pH est choisi parmi l'hydroxyde de tétrabutylammonium, l'hydroxyde de tétraméthylammonium, l'hydroxyde de potassium, l'hydroxyde de benzyltriméthylammonium et leurs mélanges.

6. Formulation selon l'une quelconque des revendications précédentes où, par rapport au poids total de la composition, le solvant acétal ou cétal est présent en une quantité de 0,01 % à 90 % en poids ; l'alcool polyhydroxylé est présent en une quantité de 1 % à 80 % en poids ; l'eau est présente en une quantité de 1 % à 80 % en poids ; et l'agent d'ajustement du pH est présent en une quantité de 0,1 % à 50 % en poids.

7. Formulation selon la revendication 6 où, par rapport au poids total de la composition, le solvant acétal ou cétal est présent en une quantité de 5 % à 55 % en poids, l'alcool polyhydroxylé est présent en une quantité de 3 % à 40 % en poids, l'eau est présente en une quantité de 5 % à 60 % en poids, et l'agent d'ajustement du pH est présent en une quantité de 0,1 % à 15 % en poids.

8. Formulation selon l'une quelconque des revendications précédentes comprenant de l'ammonium et du fluorure d'ammonium quaternaire.

9. Formulation selon la revendication 8 où l'ammonium et le fluorure d'ammonium quaternaire sont choisis parmi le fluorure de tétrabutylammonium, l'hydroxyde de tétrapropylammonium, l'hydroxyde de tétraéthylammonium, le fluorure de tétraméthylammonium, l'hydroxyde d'ammonium et leurs mélanges.

10. Formulation selon l'une quelconque des revendications précédentes comprenant un inhibiteur de corrosion.

11. Formulation selon la revendication 10 où l'inhibiteur de corrosion est choisi parmi le tolyltriazole, le benzotriazole, le pyrocatéchol, l'acide gallique et leurs mélanges.

12. Formulation selon l'une quelconque des revendications précédentes comprenant en outre un solvant organique.

13. Formulation selon la revendication 12 où le solvant organique est choisi parmi l'alcool tétrahydrofurfurylique, le propylène éther et leurs mélanges.

14. Procédé pour retirer un résidu organique et inorganique et un photorésist de substrats semi-conducteurs après la gravure, comprenant : la mise en contact du substrat avec une formulation comprenant un solvant acétal ou cétal, un agent d'ajustement du pH, de l'eau et un alcool polyhydroxylé, la formulation ayant un pH de 7 ou supérieur.

15. Procédé selon la revendication 14 où la formulation est telle que définie davantage dans l'une quelconque des revendications 1 à 13.
